# EUROPÄISCHE PATENTANMELDUNG

(11) **EP 4 455 704 A1**
(43) Veröffentlichungstag der Anmeldung: **30.10.2024**
(21) Anmeldenummer: 23169784.8
(22) Anmeldetag: 25.04.2023
(51) Int. Cl.: G01R 33/28

(54) **VERFAHREN ZU EINEM BEREITSTELLEN EINES KOLLISIONSVERMEIDUNGSMODELLS FÜR EINE BEWEGUNG EINES PATIENTENTISCHS IN EINEM PATIENTENAUFNAHMEBEREICH EINER MAGNETRESONANZVORRICHTUNG**

(71) Anmelder: Siemens Healthineers AG, 91301 Forchheim (DE)
(72) Erfinder: Krauss, Bernhard, 90559 Burgthann (DE); Leghissa, Martino, 91369 Wiesenthau (DE); Malzacher, Matthias, 90402 Nürnberg (DE)
(74) Vertreter: Siemens Healthineers Patent Attorneys

(57) **Zusammenfassung**

Die Erfindung geht aus von einem Verfahren zu einem Bereitstellen eines Kollisionsvermeidungsmodells für eine Bewegung eines Patiententischs innerhalb eines Patientenaufnahmebereich einer Magnetresonanzvorrichtung, wobei dem Patiententisch für eine Bewegung innerhalb des Patientenaufnahmebereichs zumindest zwei Freiheitgrade zur Verfügung stehen, umfassend die folgenden Verfahrensschritte:
- Bereitstellen von zumindest einer Größeninformation und/oder Positionsinformation des Patiententischs,
- Erfassen von Bilddaten eines auf dem Patiententisch positionierten Patienten,
- Ermitteln von zumindest einer Größeninformation und/oder Positionsinformation des auf dem Patiententisch positionierten Patienten anhand der erfassten Bilddaten,
- Ermitteln des Kollisionsvermeidungsmodells anhand der zumindest einen Größeninformation und/oder Positionsinformation des Patiententischs und anhand der zumindest einen Größeninformation und/oder Positionsinformation des Patienten, und
- Bereitstellen des Kollisionsvermeidungsmodells für eine Bewegung des Patiententischs innerhalb des Patientenaufnahmebereichs.

## Beschreibung

Die vorliegende Erfindung betrifft ein Verfahren zu einem Bereitstellen eines Kollisionsvermeidungsmodells für eine Bewegung eines Patiententischs in einem Patientenaufnahmebereich einer Magnetresonanzvorrichtung. Des Weiteren geht die Erfindung aus von einer Magnetresonanzvorrichtung, die zu einer Ausführung des Verfahrens zu einem Bereitstellen eines Kollisionsvermeidungsmodells für eine Bewegung eines Patiententischs in einem Patientenaufnahmebereich ausgebildet ist. Zudem geht die Erfindung aus von einem Computerprogrammprodukt, welches zur Ausführung des Verfahrens zu einem Bereitstellen eines Kollisionsvermeidungsmodells für eine Bewegung eines Patiententischs in einem Patientenaufnahmebereich ausgebildet ist.

Unabhängig vom grammatikalischen Geschlecht eines bestimmten Begriffes sind Personen mit männlicher, weiblicher oder anderer Geschlechteridentität mit umfasst.

Für eine Magnetresonanzuntersuchung eines Patienten wird dieser, insbesondere ein zu untersuchender Bereich des Patienten, innerhalb eines Patientenaufnahmebereichs einer Magnetresonanzvorrichtung positioniert. Hierzu weist die Magnetresonanzvorrichtung einen Patiententisch auf, der innerhalb des Patientenaufnahmebereichs Bewegungen in zumindest eine Raumrichtung ausführen kann. Steht für die Positionierung des Patienten ein Patiententisch zur Verfügung, der für seine Bewegung innerhalb des Patientenaufnahmebereichs mehr als einen Freiheitsgrad zur Verfügung hat, kann dies zu einer erhöhten Gefahr einer Kollisionen zwischen dem Patienten und einer den Patientenaufnahmebereich umgebende Umhausung führen. Zudem kann eine derartiger Patiententisch zu unerwünschten Quetschungen von Zubehörteilen, beispielsweise von Kabeln, führen.

Der vorliegenden Erfindung liegt insbesondere die Aufgabe zugrunde, für einen effektiven Schutz vor unerwünschten Kollisionen bei einer eine Positionierung des Patienten innerhalb des Patientenaufnahmebereichs mittels eines in zumindest zwei Freiheitsgrade bewegbaren Patiententisch bereitzustellen. Die Aufgabe wird durch die Merkmale der unabhängigen Ansprüche gelöst. Vorteilhafte Ausgestaltungen sind in den Unteransprüchen beschrieben.

Die Erfindung geht aus von einem Verfahren zu einem Bereitstellen eines Kollisionsvermeidungsmodells für eine Bewegung eines Patiententischs innerhalb eines Patientenaufnahmebereichs einer Magnetresonanzvorrichtung, wobei dem Patiententisch für eine Bewegung innerhalb des Patientenaufnahmebereiche zumindest zwei Freiheitsgrade zur Verfügung stehen, umfassend die folgenden Verfahrensschritte:
- Bereitstellen von zumindest einer Größeninformation und/oder Positionsinformation des Patiententischs,
- Erfassen von Bilddaten eines auf dem Patiententisch positionierten Patienten,
- Ermitteln von zumindest einer Größeninformation und/oder Positionsinformation es auf dem Patiententisch positionierten Patienten anhand der erfassten Bilddaten,
- Ermitteln des Kollisionsvermeidungsmodells anhand der zumindest einen Größeninformation und/oder Positionsinformation des Patiententischs und anhand der zumindest einen Größeninformation und/oder Positionsinformation des Patienten, und
- Bereitstellen des Kollisionsvermeidungsmodells für eine Bewegung des Patiententischs innerhalb des Patientenaufnahmebereichs.

Das Kollisionsvermeidungsmodell umfasst bevorzugt ein Modell des Patiententischs und des darauf positionierten Patienten. Dabei kann in das Kollisionsvermeidungsmodells auch ein Modell des Patienten, das aus der zumindest einen Größeninformation des Patienten ermittelt wird, eingehen. Aufgabe des Kollisionsvermeidungsmodells ist es, bei einem Positionieren des Patiententischs innerhalb des Patientenaufnahmebereichs in bevorzugt einer Zielposition des Patiententischs eine mögliche Kollision und/oder ein Kontakt zwischen dem Patienten und der den Patientenaufnahmebereich umgebenden Umhausung und zwischen dem Patiententisch und der den Patientenaufnahmebereich umgebenden Umhausung zu vermeiden.

Bei einer Bewegung des Patiententischs innerhalb des Patientenaufnahmebereichs wird der Patiententisch in eine Zielposition bewegt. Ein Beispiel für eine Zielposition des Patienten kann eine Positionierung eines zu untersuchenden Bereichs des Patienten in einem Isozentrum und/oder möglichst nahe am Isozentrum für die anstehende Magnetresonanzuntersuchung sein oder auch eine beliebige Position des Patiententischs innerhalb des Patientenaufnahmebereichs umfassen. Die Positionierung des Patiententischs innerhalb des Patientenaufnahmebereichs kann dabei manuell durch einen Benutzer oder auch automatisch durchgeführt werden. Für die Bewegung in diese Zielposition stehen dem Patiententisch zumindest zwei Freiheitsgrade zur Verfügung. Bevorzugt stehen dem Patiententisch für die Bewegung in diese Zielposition drei Freiheitsgrade zur Verfügung. Besonders vorteilhaft stehen dem Patiententisch für die Bewegung in diese Zielposition vier Freiheitsgrade zur Verfügung. Bevorzugt umfasst ein erster Freiheitsgrad eine Bewegung des Patiententischs in z-Richtung, insbesondere in Längsrichtung des Patientenaufnahmebereichs. Bevorzugt umfasst ein zweiter Freiheitsgrad eine Bewegung des Patiententischs in x-Richtung, insbesondere in Querrichtung des Patientenaufnahmebereichs. Bevorzugt umfasst ein dritter Freiheitsgrad eine Bewegung des Patiententischs in y-Richtung, insbesondere in Vertikalrichtung. Bevorzugt umfasst ein vierter Freiheitsgrad eine Rotationsbewegung des Patiententischs um eine Vertikalachse. Die Vertikalachse für die Rotationsbewegung kann dabei durch das Isozentrum der Magneteinheit verlaufen.

Der Patientenaufnahmebereich ist zu einer Aufnahme des Patienten, insbesondere des zu untersuchenden Bereichs des Patienten, während einer Magnetresonanzuntersuchung ausgebildet. Der Patientenaufnahmebereich ist dabei zumindest teilweise von einer Magneteinheit der Magnetresonanzvorrichtung umgeben, insbesondere zylinderförmig von der Magneteinheit umgeben. Innerhalb des Patientenaufnahmebereichs ist bevorzugt ein Field of View (FOV) und das Isozentrum der Magnetresonanzvorrichtung angeordnet. Das FOV umfasst bevorzugt einen Erfassungsbereich der Magnetresonanzvorrichtung, innerhalb dessen die Bedingungen für eine Erfassung von medizinischen Bilddaten, insbesondere Magnetresonanzbilddaten, innerhalb des Patientenaufnahmebereichs vorliegen, wie beispielsweise ein homogenes Grundmagnetfeld. Das Isozentrum der Magnetresonanzvorrichtung umfasst bevorzugt den Bereich und/oder Punkt innerhalb der Magnetresonanzvorrichtung, der die optimalen und/oder idealen Bedingungen für die Erfassung von medizinischen Bilddaten, insbesondere Magnetresonanzbilddaten, aufweist. Insbesondere umfasst das Isozentrum den homogensten Magnetfeldbereich innerhalb der Magnetresonanzvorrichtung.

Die Magnetresonanzvorrichtung umfasst bevorzugt eine medizinische und/oder diagnostische Magnetresonanzvorrichtung, die zu einem Erfassen von medizinischen und/oder diagnostischen Bilddaten, insbesondere medizinischen und/oder diagnostischen Magnetresonanzbilddaten, eines Patienten ausgelegt und/oder ausgebildet ist. Die Magnetresonanzvorrichtung umfasst die Magneteinheit mit einem Grundmagneten, einer Gradientenspuleneinheit und einer Hochfrequenzantenneneinheit.

Der Grundmagnet ist zur Erzeugung eines homogenen Grundmagnetfelds mit einer definierten Magnetfeldstärke, wie beispielsweise mit einer Magnetfeldstärke von 0,55 T oder 1,5 T oder 3 T oder 7 T usw., ausgebildet. Insbesondere ist der Grundmagnet zur Erzeugung eines starken, konstanten und homogenen Grundmagnetfelds ausgebildet. Das homogene Grundmagnetfeld ist bevorzugt innerhalb eines Patientenaufnahmebereichs der Magnetresonanzvorrichtung angeordnet und/oder vorzufinden.

Das Bereitstellen der zumindest einen Größeninformation und/oder Positionsinformation des Patiententischs erfolgt bevorzugt mittels einer Bereitstellungseinheit. Dabei kann die Bereitstellungseinheit zu einem Erfassen der zumindest einen Größeninformation und/oder Positionsinformation ausgebildet sein, wie beispielsweise mittels einer Kamera. Zudem kann die Bereitstellungseinheit auch eine Speichereinheit und/oder eine Datenbank umfassen, in der die zumindest eine Größeninformation und/oder Positionsinformation des Patiententischs gespeichert ist. Beispielsweise kann bei einer definierten Ausgangsposition des Patiententischs mit vorbestimmten Positionsinformationen auf eine Erfassung der zumindest einen Grö-βeninformation und/oder Positionsinformation verzichtet werden. Die Größeninformation umfasst bevorzugt eine Ausdehnung des Patiententischs in zumindest zwei Raumrichtungen, bevorzugt in drei Raumrichtungen. Insbesondere umfasst die Grö-βeninformation des Patiententischs eine Länge des Patiententischs und eine Breite des Patiententischs. Bevorzugt umfasst die Größeninformation des Patiententischs auch eine Höhe des Patiententischs. Die Positionsinformation umfasst bevorzugt eine Position des Patiententischs bezüglich der Magneteinheit, insbesondere des Patientenaufnahmebereichs der Magneteinheit.

Das Erfassen von Bilddaten des auf dem Patiententisch positionierten Patienten erfolgt mittels einer Erfassungseinheit. Die Erfassungseinheit kann dabei eine Kamera umfassen, wie beispielsweise eine 2D-Kamera oder auch eine 3D-Kamera. Alternativ oder zusätzlich kann das Erfassen von Bilddaten auch mittels der Magneteinheit erfolgen, beispielsweise mittels eines Lokalisierungs-Scans.

Umfasst die Erfassungseinheit eine Kamera, kann mittels der Kamera auch die zumindest eine Größeninformation und/oder Positionsinformation des Patiententischs bereitgestellt werden.

Insbesondere kann dabei die Größeninformation und/oder Positionsinformation des Patiententischs vor einem Positionieren des Patienten erfasst werden, um ein Vergleichsbild des Patiententischs zu erhalten und ein Überstehen des Patienten über eine Lagerungsfläche des Patiententischs zu ermitteln und/oder bei der Ermittlung des Kollisionsvermeidungsmodells zu berücksichtigen. Bevorzugt weist der Patiententisch für das Erfassen der Größeninformation und/oder Positionsinformation des Patiententischs und für das Erfassen der Größeninformation und/oder Positionsinformation des Patienten eine gleiche Position auf.

Das Ermitteln der zumindest einen Größeninformation des auf dem Patiententisch positionierten Patienten erfolgt bevorzugt mittels einer Ermittlungseinheit. Die Ermittlungseinheit weist bevorzugt ein Rechenmodul und/oder einen Prozessor auf zu einem automatischen und/oder selbsttätigen Ermitteln der zumindest einen Größeninformation des auf dem Patiententisch positionierten Patienten anhand der erfassten Bilddaten. Die Größeninformation des auf dem Patiententisch positionierten Patienten umfasst bevorzugt eine Ausdehnung des Patienten in zumindest zwei Raumrichtungen, bevorzugt in drei Raumrichtungen. Die Positionsinformation des auf dem Patiententisch positionierten Patienten umfasst bevorzugt eine Position des Patienten bezüglich des Patiententischs. Insbesondere umfasst die Größeninformation des Patienten eine Länge des Patienten und eine Breite des Patienten. Bevorzugt umfasst die Grö-βeninformation des Patienten auch eine Dicke des Patienten.

Das Ermitteln des Kollisionsvermeidungsmodell erfolgt mittels der Ermittlungseinheit. Das Kollisionsvermeidungsmodell umfasst bevorzugt ein Modell des Patienten zusammen mit dem Patiententisch. Im einfachsten Fall eine rechteckige Querschnittsfläche festgelegt werden, insbesondere eine Ausdehnungen in der x-y-Ebene als Rechteck festgelegt werden, anhand dessen als 3D-Modell ein Cubus ermittelt und/oder festgelegt wird. Das Kollisionsvermeidungsmodell kann zudem eine Geometrie einer den Patientenaufnahmebereich umgebenden Umhausung umfassen.

Das Bereitstellen des Kollisionsvermeidungsmodells erfolgt mittels einer Bereitstellungseinheit. Die Bereitstellungseinheit kann dabei von der Ermittlungseinheit umfasst sein. Zudem kann die Bereitstellungseinheit auch eine Speichereinheit und/oder eine Datenbank umfassen, in der das Kollisionsvermeidungsmodell hinterlegt werden kann.

Zu einer Simulation und/oder Modellierung einer Bewegung des Patiententischs kann von der Ermittlungseinheit in dem Kollisionsvermeidungsmodell das Modell des Patienten zusammen mit dem Patiententischs in einem Modell des Patientenaufnahmebereichs verschoben und/oder bewegt werden damit eine kollisionsfreie Bewegung ermittelt werden. Insbesondere kann derart einfach eine kollisionsfreie Bewegung des Patiententisch mit zumindest zwei Freiheitsgraden, bevorzugt zumindest drei Freiheitsgraden und besonders vorteilhaft vier Freiheitsgraden, für eine Positionierung des Patienten, insbesondere des zu untersuchenden Bereichs des Patienten, innerhalb des Patientenaufnahmebereichs ermittelt werden. Dabei kann ein effektiver Schutz des Patienten vor unerwünschten Kollisionen und/oder einem unerwünschten Kontakt zwischen dem Patienten und der den Patientenaufnahmebereich umgebenden Umhausung bei einer Positionierung des Patienten innerhalb des Patientenaufnahmebereichs bereitgestellt werden. Insbesondere kann derart ein Kollisionsvermeidungsmodell bereitgestellt werden, das individualisiert an den zu untersuchenden Patienten durch die Einbeziehung von aktuellen Größeninformationen des Patienten bei der Ermittlung des Kollisionsvermeidungsmodells angepasst ist.

In einer vorteilhaften Weiterbildung des erfindungsgemäßen Verfahrens kann es vorgesehen sein, dass das Bereitstellen der zumindest einen Größeninformation und/oder Positionsinformation des Patiententischs eine Größeninformation und/oder Positionsinformation einer am Patiententisch angeordnete Zubehöreinheit umfasst. Die zumindest eine Zubehöreinheit kann beispielsweise ein zusätzliches Lagerungselement und/oder weitere Einheiten, die über den Patiententisch, insbesondere über eine Lagerfläche des Patiententischs, hinausstehen, umfassen. Beispielsweise kann die zumindest eine Zubehöreinheit eine zusätzliche Armablage, die seitlich am Patiententisch angeordnet ist, umfassen, wie sie insbesondere bei großen und/oder adipös veranlagten Patienten verwendet wird. Bevorzugt wird die Größeninformation und/oder Positionsinformation der zumindest einen Zubehöreinheit bei der Ermittlung des Kollisionsvermeidungsmodells berücksichtigt, so dass auch über die Lagerfläche des Patiententischs hinausreichende Zubehöreinheiten kollisionsfrei mit der den Patientenaufnahmebereich umgebenden Umhausung bei einer Bewegung des Patiententischs innerhalb des Patientenaufnahmebereichs sind.

In einer vorteilhaften Weiterbildung des erfindungsgemäßen Verfahrens kann es vorgesehen sein, dass das Erfassen der Bilddaten mittels einer Kamera erfolgt, wobei die Kamera außerhalb des Patientenaufnahmebereichs angeordnet ist. Besonders vorteilhaft umfasst die Kamera eine 3D-Kamera, so dass besonders einfache eine dreidimensionale Größeninformation und/oder Positionsinformation des Patienten erfasst und/oder ermittelt werden kann. Insbesondere kann derart direkt aus den erfassten Bilddaten eine dreidimensionale Ausdehnung des Patienten bezüglich des Patiententischs ermittelt werden. Alternativ hierzu kann die Kamera auch eine 2D-Kamera umfassen. Bevorzugt ist die Kamera dabei derart außerhalb des Patientenaufnahmebereichs angeordnet, dass sich ein Sichtfeld der Kamera von oben auf den Patiententisch und/oder auf den auf dem Patiententisch angeordneten Patienten erstreckt. Dabei kann die Kamera an einer Frontseite der Magnetresonanzvorrichtung oder an einer Decke des Untersuchungsraums, in dem die Magnetresonanzvorrichtung angeordnet ist, angeordnet sein. Dabei kann eine vorteilhafte, insbesondere unverdeckte, Sicht auf den Patienten und/oder den Patiententisch erreicht werden.

In einer vorteilhaften Weiterbildung des erfindungsgemäßen Verfahrens kann es vorgesehen sein, dass das Erfassen von Bilddaten mittels einer Magneteinheit der Magnetresonanzvorrichtung erfolgt. Beispielsweise können dabei mittels eines schnellen Lokalisierungs-Scans die Bilddaten erfasst werden. Mittels des Lokalisierungs-Scans werden bevorzugt Schichten mit unterschiedlicher räumliche Orientierung erfasst. Dabei wird zumindest eine transversale Schicht oder auch mehrere Schichten, die auch eine andere Orientierung aufweisen können, des Patienten innerhalb des Patientenaufnahmebereichs erfasst. Bevorzugt umfasst hierbei die aus den Bilddaten ermittelte Größeninformation zumindest einen Querschnitt des Patienten und/oder eine Position des Patienten in Querrichtung und Vertikalrichtung des Patientenaufnahmebereichs. Zudem kann die aus den Bilddaten ermittelte Größeninformation auch eine Länge des Patienten umfassen. Bevorzugt wird hierzu der Patiententisch in einer zentralen Position innerhalb des Patientenaufnahmebereichs positioniert, insbesondere in Querrichtung und/oder in Vertikalrichtung des Patientenaufnahmebereichs, bei der eine Kollision des Patienten und/oder des Patiententischs mit der den Patientenaufnahmebereich umgebenden Umhausung ausgeschlossen ist und/oder eine Wahrscheinlichkeit einer Kollision sehr gering ist. Derart kann ohne zusätzliche Hardware, beispielsweise eine ohne zusätzliche Kamera, eine Größeninformation und/oder Positionsinformation des Patienten bereitgestellt werden.

In einer vorteilhaften Weiterbildung des erfindungsgemäßen Verfahrens kann es vorgesehen sein, dass bei der Ermittlung der zumindest einen Größeninformation und/oder Positionsinformation des auf dem Patiententisch positionierten Patienten Projektionseffekte reduziert und/oder eliminiert werden. Die Projektionseffekte resultieren insbesondere aus der Erfassung der Bilddaten mittels einer Kamera, wobei ein Abstand zwischen der Kamera und dem Patienten relativ gering ist und/oder eine Position des Patiententischs in Vertikalrichtung keine definierte und/oder standardisierte Position des Patiententisch umfasst. Umfasst die Kamera eine 3D-Kamera, können derartige Projektionseffekte direkt erfasst werden, indem eine seitliche Ausdehnung des Patienten, insbesondere ein seitlicher Überstand des Patienten über den Patiententisch, und eine Oberseite der seitlichen Ausdehnung, insbesondere des seitlichen Überstands über den Patiententisch, direkt aus den erfassten Bilddaten ermittelt und/oder gemessen werden kann. Umfasst die Kamera dagegen eine 2D-Kamera, kann der seitliche Überstand auf die Höhe und/oder das Niveau des Patiententischs, insbesondere eine Lagerungsfläche des Patiententischs, projiziert werden und mittels einer Abschätzung eine Ausdehnung des Patienten ermittelt werden. Zudem können auch Größeninformationen und/oder Positionsinformationen von Zubehöreinheiten dazu verwendet werden, eine Ausdehnung des Patienten zu bestimmen und damit unerwünschte Projektionseffekte zu reduzieren und/oder zu eliminieren. Beispielsweise kann eine Positionsinformation und/oder eine Grö-βeninformation einer Armablage zu einer Abschätzung einer seitlichen Ausdehnung des Patienten auf dem Patiententisch herangezogen und/oder verwendet werden.

In einer vorteilhaften Weiterbildung des erfindungsgemäßen Verfahrens kann es vorgesehen sein, dass zur Ermittlung der zumindest einen Größeninformation und/oder Positionsinformation des Patienten zusätzliche Patienteninformationen berücksichtigt werden. Derartige zusätzlich Patienteninformationen können beispielsweise eine Größe und/oder ein Gewicht und/oder ein Alter und/oder ein Geschlecht usw. des Patienten umfassen. Dabei kann anhand der aus den Bilddaten ermittelten Größeninformationen, insbesondere aus Magnetresonanzbilddaten ermittelte Größeninformationen, des Patienten zusammen mit diesen zusätzlichen Informationen ein Patientenmodell, bevorzugt ein 3D-Patientenmodell, bestimmt werden. Zudem kann ein Gewicht des Patienten mittels Gewichtssensoren, die am Patiententisch und/oder innerhalb des Patiententischs angeordnet sind, ermittelt und bereitgestellt werden.

In einer vorteilhaften Weiterbildung des erfindungsgemäßen Verfahrens kann es vorgesehen sein, dass zur Ermittlung des Kollisionsvermeidungsmodells geometrische Modelle verwendet werden, wobei eine Zuordnung der geometrischen Modelle zu der zumindest einen Größeninformation des Patienten in einer Speichereinheit gespeichert ist. Die Speichereinheit kann dabei von der Ermittlungseinheit umfasst sein oder auch separat zur Ermittlungseinheit ausgebildet sein. Dabei kann die Zuordnung zu der zumindest einen Größeninformation zu einem geometrischen Modell tabellarisch ausgebildet sein. Dabei kann anhand einer ermittelten Bereite und/oder Höhe des Patienten eine Querschnittsfläche des geometrisches Modells des Patienten bestimmt werden. Das geometrische Modell kann beispielsweise einen rechteckigen Querschnitt und/oder einen elliptischen Querschnitt usw. umfassen, der beispielsweise eine Grundfläche für einen Zylinder und/oder Cubus umfasst. Derart kann besonders schnell anhand der zumindest einen Größeninformation ein Patientenmodell zur Ermittlung des Kollisionsvermeidungsmodells ermittelt und/oder bereitgestellt werden.

In einer vorteilhaften Weiterbildung des erfindungsgemäßen Verfahrens kann es vorgesehen sein, dass anhand des bereitgestellten Kollisionsvermeidungsmodells eine Bewegung des Patiententischs kontrolliert wird. Für eine Kontrolle einer Bewegung des Patiententischs kann eine Zielposition ermittelt werden, in der der Patiententisch positioniert werden soll. Die Zielposition kann dabei eine Position des Patiententischs innerhalb des Patientenaufnahmebereichs umfassen. Das Kollisionsvermeidungsmodell wird bevorzugt bei jeder Bewegung des Patiententischs innerhalb des Patientenaufnahmebereichs verwendet, um eine sichere und kollisionsfreie Bewegung zu ermöglichen. Zudem kann auch eine geplante Bewegung des Patiententischs von der Ermittlungseinheit in mehrere Teilschritte unterteilt werden, wobei eine Bewegung für jeden der Teilschritte auf Grundlage des Kollisionsvermeidungsmodells ermittelt wird. Vorzugsweise erfolgt das Ermitteln der Zielposition und/oder eine Bewegung des Patiententisch in die Zielposition mittels der Ermittlungseinheit.

Beispielsweise kann die Zielposition anhand eines zu untersuchenden Bereichs des Patienten ermittelt werden. Die Zielposition des Patiententisch kann dabei eine Untersuchungsposition, in der sich der Patiententisch während der anstehenden Magnetresonanzuntersuchung befindet, umfassen. In dieser Zielposition, insbesondere der Untersuchungsposition, ist der zu untersuchende Bereich mit minimal möglichen Abstand zum Isozentrum positioniert, ohne dass dabei eine Kollision und/oder ein Kontakt zwischen dem Patienten und der den Patientenaufnahmebereich umgebenden Umhausung vorliegt. Der zu untersuchende Bereich des Patienten umfasst bevorzugt denjenigen Bereich, der zu einer Klärung einer medizinischen und/oder diagnostischen Fragestellung einer Magnetresonanzuntersuchung unterzogen werden soll. Der minimal mögliche Abstand des zu untersuchenden Bereichs zum Isozentrum ist somit auch abhängig von einer Position des zu untersuchenden Bereichs innerhalb des Patienten. Beispielsweise kann ein eine Hüfte des Patienten umfassender zu untersuchender Bereich bezogen auf die z-Richtung und die y-Richtung im Isozentrum angeordnet sein, jedoch bezogen auf die x-Richtung aufgrund einer möglichen Kollision mit der den Patientenaufnahmebereich umgebenden Umhausung neben dem Isozentrum angeordnet sein.

Das anschließende Positionieren des Patiententisch kann dabei manuell durch einen Bediener erfolgen oder auch automatisch und/oder selbsttätig. Vorzugsweise weist hierzu der Patiententisch eine Antriebseinheit für eine Generierung eines Antriebsmoments auf für eine Bewegung des Patiententischs in die Zielposition. Zudem weist der Patiententisch bevorzugt eine Einstelleinheit, die zu einer Einstellung und/oder Positionierung des Patiententisch innerhalb des Patientenaufnahmebereichs ausgebildet ist. Für die Positionierung des Patiententischs in die Zielposition stehen der Einstelleinheit zumindest zwei Freiheitsgrade, bevorzugt drei Freiheitsgrade und besonders vorteilhaft vier Freiheitsgrade zur Verfügung. Bei einem manuellen Positionieren erfolgt eine Steuerung der Antriebseinheit und/oder der Einstelleinheit durch den Bediener. Bei einer automatischen und/oder selbsttätigen Positionierung erfolgt eine Steuerung der Antriebseinheit und/oder der Einstelleinheit durch eine Steuereinheit und/oder eine Recheneinheit.
Derart kann ein einfaches und sicheres Positionieren des Patiententischs und damit des zu untersuchenden Bereichs des Patienten für eine Magnetresonanzuntersuchung ermöglicht werden. Zudem kann derart eine vorteilhafte Unterstützung eines Bedienpersonals bei der Positionierung des Patienten erreicht werden und damit eine fehlerhafte Positionierung verhindert werden. Des Weiteren kann damit auch ein Sicherheitsrisiko für den Patienten bei einer Positionierung innerhalb des Patientenaufnahmebereichs reduziert werden. Insbesondere können derart unerwünschte Kollisionen und/oder Kontakte des Patienten mit der den Patientenaufnahmebereich umgebenden Umhausung während der Positionierung des Patiententischs innerhalb des Patientenaufnahmebereichs verhindert werden.

In einer vorteilhaften Weiterbildung des erfindungsgemäßen Verfahrens kann es vorgesehen sein, dass nach einem Positionieren des Patiententischs eine Positionsüberwachung des Patiententischs hinsichtlich einer Biegung des Patiententischs erfolgt, wobei die Überwachung mittels der Magneteinheit und/oder zumindest eines am Patiententisch angeordneten Sensors erfolgt. Eine Biegung des Patiententischs umfasst bevorzugt eine Biegung des Patiententischs in Längsrichtung des Patiententischs. Dabei kann eine Biegung des Patiententischs erfolgen, wenn der Patiententisch nur außerhalb des Patientenaufnahmebereichs abgestützt ist, wie beispielsweise an einer Basiseinheit der Patientenlagerungsvorrichtung, und innerhalb des Patientenaufnahmebereichs keine Lagerelemente und/oder Abstützelemente zur Lagerung und/oder Abstützung des Patiententischs angeordnet sind. Zudem kann auch eine Biegung des Patiententischs bei einem Abstützen von beispielsweise einem Arzt für einen medizinischen Eingriff und/oder einer medizinischen Intervention während einer Magnetresonanzuntersuchung erfolgen.

Die Biegung des Patiententischs kann beispielsweise mittels Sensoren, insbesondere optischer Glasfasersensoren, erfasst werden. Derartige Sensoren sind dabei bevorzugt innerhalb des Patiententischs angeordnet und/oder integriert. Zudem kann die Biegung auch mittels Magnetresonanzdaten, beispielsweise mittels sagittaler Schnittbilder erfasst werden. Hierzu kann eine Anatomie des Patienten anhand definierter Landmarken vermessen werden oder es können zusätzliche Marker, insbesondere am Patiententisch angeordnet sein. Vorzugsweise erfolgt während der gesamten Magnetresonanzuntersuchung eine stetige Überwachung einer Position des Patiententischs, so dass stets eine aktuelle Position und/oder eine temporäre Biegung des Patiententischs bei der Bestimmung der Zielposition berücksichtigt werden kann. Insbesondere können derart Korrekturen vorgenommen werden, wenn eine Positionsänderung, beispielsweise eine Biegung des Patiententischs, zu einer möglichen Kollision des Patienten mit der den Patientenaufnahmebereich umgebenden Umhausung führen könnte oder auch zu einer Beeinträchtigung von Zubehörteilen, beispielsweise zu einem Einklemmen und/oder Quetschen von Kabeln und/oder Leitungen.

Die Sensoren zur Erfassung einer Biegung des Patiententischs können zusätzlich auch als Gewichtssensoren ausgebildet sein, mittels denen ein Gewicht des Patienten erfasst werden kann.

In einer vorteilhaften Weiterbildung des erfindungsgemäßen Verfahrens kann es vorgesehen sein, dass nach einem Positionieren des Patiententischs eine Überwachung einer Position des Patienten erfolgt. Bevorzugt erfolgt die Überwachung der Position des Patienten mittels der erfassten Magnetresonanzdaten. Dabei wird insbesondere die Position des Patienten bezüglich des Patiententischs überwacht, ob der Patient sich während der Magnetresonanzuntersuchung bewegt hat oder nicht. Vorzugsweise erfolgt während der gesamten Magnetresonanzuntersuchung eine stetige Überwachung einer Position des Patienten, so dass stets eine aktuelle Position und/oder eine Bewegung des Patienten bei der Bestimmung der Zielposition unter Vermeidung einer möglichen Kollision zwischen dem Patienten und dem den Patientenaufnahmebereich umgebenden Umhausung berücksichtigt werden kann.

In einer vorteilhaften Weiterbildung des erfindungsgemäßen Verfahrens kann es vorgesehen sein, dass eine Korrektur des Kollisionsvermeidungsmodells anhand der Positionsänderung des Patienten und/oder der Positionsänderung des Patiententischs ermittelt wird. Beispielsweise kann eine derartige Korrektur eine Drehung und/oder eine Verschiebung eines Patientenmodells umfassen. Zudem kann auch eine derartige Korrektur eine Vergrößerung eines Querschnitts des Patientenmodells und/oder eines Modells des Patiententischs umfassen. Diese Ausgestaltung der Erfindung weist den Vorteil auf, dass auch während der gesamten Magnetresonanzuntersuchung der Patient vor einer unerwünschten Kollision und/oder einer unerwünschten Berührung mit der den Patientenaufnahmebereich umgebenden Umhausung vorteilhaft geschützt werden kann. Insbesondere können hierdurch auch Verletzungen des Patienten verhindert werden oder auch eine SAR-Belastung des Patienten während der Magnetresonanzuntersuchung gering gehalten werden. Zudem kann derart auch eine Beeinträchtigung und/oder eine Beschädigung von Zubehörteilen, beispielsweise ein Einklemmen und/oder Quetschen von Kabeln und/oder Leitungen, vorteilhaft während der gesamten Magnetresonanzuntersuchung verhindert werden.

Des Weiteren geht die Erfindung aus von einer Magnetresonanzvorrichtung mit einer Magneteinheit, einen von der Magneteinheit zumindest teilweise umgebenen Patientenaufnahmebereich und einen innerhalb des Patientenaufnahmebereichs bewegbaren Patiententisch, wobei die Magnetresonanzvorrichtung zu einem Ausführen eines Verfahrens zu einem Bereitstellen eines Kollisionsvermeidungsmodells für eine Bewegung des Patiententischs innerhalb des Patientenaufnahmebereich ausgebildet ist.

Bevorzugt umfasst die Magnetresonanzvorrichtung eine Bereitstellungseinheit, die zu einem Bereitstellen von zumindest einer Größeninformation und/oder Positionsinformation des Patiententischs ausgebildet ist.

Des Weiteren umfasst die Magnetresonanzvorrichtung eine Erfassungseinheit, die zu einem Erfassen von Bilddaten eines auf dem Patiententisch positionierten Patienten ausgebildet ist. Die Erfassungseinheit kann dabei eine Kamera umfassen. Alternativ hierzu kann die Erfassungseinheit auch die Magneteinheit umfassen.

Des Weiteren umfasst die Magnetresonanzvorrichtung eine Ermittlungseinheit, die zu einem Ermitteln von zumindest einer Größeninformation und/oder Positionsinformation des auf dem Patiententisch positionierten Patienten anhand der erfassten Bilddaten ausgebildet ist. Bevorzugt ist die Ermittlungseinheit auch zu einem Ermitteln des Kollisionsvermeidungsmodells anhand der zumindest einen Größeninformation und/oder Positionsinformation des Patiententischs und anhand der zumindest einen Größeninformation und/oder Positionsinformation des Patienten ausgebildet.

Die Ermittlungseinheit umfasst bevorzugt ein zumindest ein Rechenmodul und/oder einen Prozessor. So ist insbesondere die Ermittlungseinheit dazu ausgebildet, computerlesbare Instruktionen auszuführen. Insbesondere umfasst die Ermittlungseinheit eine Speichereinheit, wobei auf der Speichereinheit computerlesbare Informationen gespeichert sind, wobei die Ermittlungseinheit dazu ausgebildet ist, die computerlesbaren Informationen von der Speichereinheit zu laden und die computerlesbaren Informationen auszuführen. Die Komponenten der Ermittlungseinheit können zum überwiegenden Teil in Form von Softwarekomponenten ausgebildet sein. Grundsätzlich können diese Komponenten aber auch zum Teil, insbesondere wenn es um besonders schnelle Berechnungen geht, in Form von softwareunterstützten Hardwarekomponenten, beispielsweise FPGAs oder dergleichen, realisiert sein. Ebenso können die benötigten Schnittstellen, beispielsweise wenn es nur um eine Übernahme von Daten aus anderen Softwarekomponenten geht, als Softwareschnittstellen ausgebildet sein. Sie können aber auch als hardwaremäßig aufgebaute Schnittstellen ausgebildet sein, die durch geeignete Software angesteuert werden. Selbstverständlich ist es auch denkbar, dass mehrere der genannten Komponenten in Form einer einzelnen Softwarekomponente bzw. softwareunterstützter Hardwarekomponente zusammengefasst realisiert sind.

Zudem weist die Magnetresonanzvorrichtung eine weitere Bereitstellungseinheit auf, die zu einem Bereitstellen des Kollisionsvermeidungsmodells für eine Bewegung des Patiententischs innerhalb des Patientenaufnahmebereichs ausgebildet ist.

Es kann ein effektiver Schutz des Patienten vor unerwünschten Kollisionen und/oder einem unerwünschten Kontakt mit einer den Patientenaufnahmebereich umgebenden Umhausung bei einer Positionierung des Patienten innerhalb des Patientenaufnahmebereichs bereitgestellt werden. Hierdurch kann vorteilhaft eine hohe Sicherheit des Patienten während der Magnetresonanzuntersuchung bereitgestellt werden. Insbesondere kann derart ein Kollisionsvermeidungsmodell bereitgestellt werden, das individualisiert an den zu untersuchenden Patienten durch die Einbeziehung von aktuellen Größeninformationen des Patienten bei der Ermittlung des Kollisionsvermeidungsmodells angepasst ist. Des Weiteren kann derart einfach und schnell eine kollisionsfreie Bewegung des Patiententisch mit zumindest zwei Freiheitsgraden, bevorzugt zumindest drei Freiheitsgraden und besonders vorteilhaft vier Freiheitsgraden, für eine Positionierung des Patienten, insbesondere des zu untersuchenden Bereichs des Patienten, innerhalb des Patientenaufnahmebereichs ermittelt werden.

Die Vorteile der erfindungsgemäßen Magnetresonanzvorrichtung entsprechen im Wesentlichen den Vorteilen des erfindungsgemäßen Verfahrens zu einem Bereitstellen eines Kollisionsvermeidungsmodells für eine Bewegung eines Patiententischs innerhalb eines Patientenaufnahmebereich einer Magnetresonanzvorrichtung, welche vorab im Detail ausgeführt sind. Hierbei erwähnte Merkmale, Vorteile oder alternative Ausführungsformen können ebenso auf die anderen beanspruchten Gegenstände übertragen werden und umgekehrt.

In einer vorteilhaften Weiterbildung der erfindungsgemäßen Magnetresonanzvorrichtung kann es vorgesehen sein, dass der Patiententisch für eine Bewegung innerhalb des Patientenaufnahmebereichs zumindest zwei Freiheitsgrade aufweist. Bevorzugt weist der Patiententisch zumindest drei Freiheitsgrade für eine Bewegung innerhalb des Patientenaufnahmebereichs auf. Besonders vorteilhaft weist der Patiententisch vier Freiheitsgrade für eine Bewegung innerhalb des Patientenaufnahmebereichs auf. Dies ermögliche eine vorteilhafte Positionierung des Patienten, insbesondere des zu untersuchenden Bereiches des Patienten, in mehrere Raumrichtungen. Insbesondere kann derart auch ein Raum innerhalb des Patientenaufnahmebereichs für die Positionierung des Patienten ausgenutzt werden, wenn der Patientenaufnahmebereich einen Durchmesser von beispielsweise 70 cm oder 80 cm und mehr aufweist.

In einer vorteilhaften Weiterbildung der erfindungsgemäßen Magnetresonanzvorrichtung kann es vorgesehen sein, dass die Magnetresonanzvorrichtung eine Kamera aufweist, die außerhalb des Patientenaufnahmebereichs angeordnet ist und die zu einer Erfassung zumindest eine Größeninformation und/oder Positionsinformation des Patienten und/oder des Patiententischs ausgebildet ist. Derart kann vorteilhaft bereits vor einer ersten Positionierung des Patiententischs und damit des Patienten innerhalb des Patientenaufnahmebereichs das Kollisionsvermeidungsmodell bestimmt werden. Somit kann bereist bei einem ersten Positionieren des Patienten innerhalb des Patientenaufnahmebereichs eine hohe Sicherheit für den Patienten bereitgestellt werden und ein Kollisionsrisiko und/oder eine Kontaktrisiko des Patienten mit der den Patientenaufnahmebereich umgebenden Umhausung reduziert werden. Zudem kann auch eine Verletzungsgefahr für den Patienten reduziert werden.

In einer vorteilhaften Weiterbildung der erfindungsgemäßen Magnetresonanzvorrichtung kann es vorgesehen sein, dass der Patiententisch zumindest einen Sensor aufweist, der zu einem Erfassen einer Biegung des Patiententischs und/oder zu einer Erfassung eines Patientengewichts ausgebildet ist. Der zumindest eine Sensor kann beispielsweise einen optischen Glasfasersensor umfassen. Bevorzugt ist der zumindest eine Sensor innerhalb des Patiententischs angeordnet und/oder integriert. Derart kann eine besonders schnelle und direkte Erfassung einer Biegung und damit einer Positionsänderung des Patiententischs erfasst werden. Zudem kann derart auch ein aktuelles Patientengewicht für eine Bestimmung eines Patientenmodells zur Verfügung stehen. Zudem können derartige Sensoren besonders platzsparend innerhalb des Patiententischs integriert werden.

Des Weiteren geht die Erfindung aus von einem Computerprogrammprodukt, welches ein Programm umfasst und direkt in einem Speicher einer programmierbaren Recheneinheit ladbar ist, mit Programmmitteln, um ein Verfahren zu einem Bereitstellen eines Kollisionsvermeidungsmodells für eine Bewegung eines Patiententischs innerhalb eines Patientenaufnahmebereich einer Magnetresonanzvorrichtung auszuführen, wenn das Programm in der Recheneinheit ausgeführt wird. Dabei benötigt das Computerprogramm eventuell Programmmittel, z.B. Bibliotheken und Hilfsfunktionen, um die entsprechenden Ausführungsformen des Verfahrens zu realisieren. Das Computerprogramm kann dabei eine Software mit einen Quellcode, der noch kompiliert und gebunden oder der nur interpretiert werden muss, oder einen ausführbaren Softwarecode umfassen, der zur Ausführung nur noch in eine entsprechende Recheneinheit zu laden ist.

Das erfindungsgemäße Computerprogrammprodukt ist direkt in einen Speicher einer programmierbaren Recheneinheit ladbar und weist Programmcode-Mittel auf, um ein erfindungsgemäßes Verfahren auszuführen, wenn das Computerprogrammprodukt in der Recheneinheit ausgeführt wird. Das Computerprogrammprodukt kann ein Computerprogramm sein oder ein Computerprogramm umfassen. Dadurch kann das erfindungsgemäße Verfahren schnell, identisch wiederholbar und robust ausgeführt werden. Das Computerprogrammprodukt ist derart konfiguriert, dass es mittels der Recheneinheit die erfindungsgemäßen Verfahrensschritte ausführen kann. Die Recheneinheit muss dabei jeweils die Voraussetzungen wie beispielsweise einen entsprechenden Arbeitsspeicher, eine entsprechende Grafikkarte oder eine entsprechende Logikeinheit aufweisen, so dass die jeweiligen Verfahrensschritte effizient ausgeführt werden können. Das Computerprogrammprodukt ist beispielsweise auf einem computerlesbaren Medium gespeichert oder auf einem Netzwerk oder Server hinterlegt, von wo es in den Prozessor einer lokalen Recheneinheit geladen werden kann, der mit der Magnetresonanzvorrichtung direkt verbunden oder als Teil ausgebildet sein kann. Weiterhin können Steuerinformationen des Computerprogrammprodukts auf einem elektronisch lesbaren Datenträger gespeichert sein. Die Steuerinformationen des elektronisch lesbaren Datenträgers können derart ausgestaltet sein, dass sie bei Verwendung des Datenträgers in einer Recheneinheit ein erfindungsgemäßes Verfahren ausführen. So kann das Computerprogrammprodukt auch den elektronisch lesbaren Datenträger darstellen. Beispiele für elektronisch lesbare Datenträger sind eine DVD, ein Magnetband, eine Festplatte oder ein USB-Stick, auf welchem elektronisch lesbare Steuerinformationen, insbesondere Software (vgl. oben), gespeichert ist. Wenn diese Steuerinformationen (Software) von dem Datenträger gelesen und in eine Steuerung und/oder Recheneinheit gespeichert werden, können alle erfindungsgemäßen Ausführungsformen der vorab beschriebenen Verfahren durchgeführt werden. So kann die Erfindung auch von dem besagten computerlesbaren Medium und/oder dem besagten elektronisch lesbaren Datenträger ausgehen.

Weitere Vorteile, Merkmale und Einzelheiten der Erfindung ergeben sich aus dem im Folgenden beschriebenen Ausführungsbeispiel sowie anhand der Zeichnungen.

Es zeigen:
- Fig. 1: eine erfindungsgemäßen Magnetresonanzvorrichtung in einer schematischen Darstellung,
- Fig. 2: ein erfindungsgemäßes Verfahren zu einem Bereitstellen eines Kollisionsvermeidungsmodells für eine Bewegung eines Patiententischs innerhalb eines Patientenaufnahmebereich der Magnetresonanzvorrichtung, und
- Fig. 3: eine Ansicht eine Kollisionsmodells mit einem Patientenmodell.

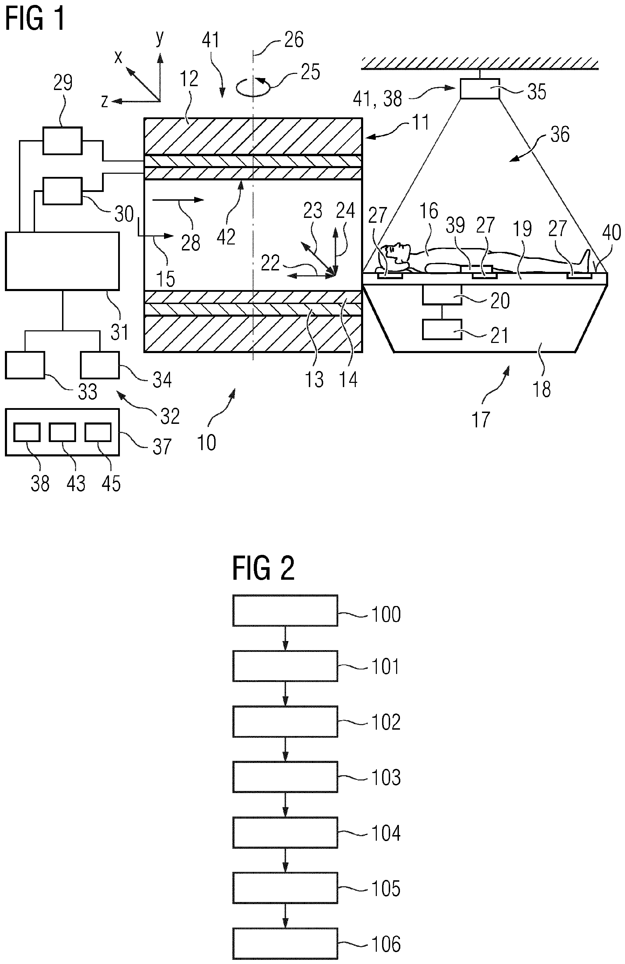

In der Fig. 1 ist eine Magnetresonanzvorrichtung 10 schematisch dargestellt. Die Magnetresonanzvorrichtung 10 umfasst eine Magneteinheit 11 mit einem Grundmagneten 12, einer Gradientenspuleneinheit 13 und einer Hochfrequenzantenneneinheit 14. Zudem weist die Magnetresonanzvorrichtung 10 einen Patientenaufnahmebereich 15 auf zu einer Aufnahme eines Patienten 16. Der Patientenaufnahmebereich 15 im vorliegenden Ausführungsbeispiel ist zylinderförmig ausgebildet und in einer Umfangsrichtung von der Magneteinheit 11 zylinderförmig umgeben. Grundsätzlich ist jedoch eine davon abweichende Ausbildung des Patientenaufnahmebereichs 15 jederzeit denkbar.

Für eine Positionierung des Patienten 16, insbesondere eines zu untersuchenden Bereichs des Patienten 16, innerhalb des Patientenaufnahmebereichs 15 weist die Magnetresonanzvorrichtung 10 eine Patientenlagerungsvorrichtung 17 auf. Die Patientenlagerungsvorrichtung 17 weist eine Basiseinheit 18 und einen bezüglich der Basiseinheit 18 bewegbaren Patiententisch 19 auf. Der Patiententisch 19 ist für eine Positionierung des Patienten 16, insbesondere des zu untersuchenden Bereichs des Patienten 16, innerhalb des Patientenaufnahmebereichs 15 bewegbar innerhalb des Patientenaufnahmebereichs 15 ausgebildet. Für eine Bewegung des Patiententischs 19 innerhalb des Patientenaufnahmebereichs 15 weist die Patientenlagerungsvorrichtung 17 eine Einstelleinheit 20 und eine Antriebseinheit 21 auf. Mittels der Antriebseinheit 21 wird ein Antriebsmoment generiert, das mittels der Einstelleinheit 20 in eine Bewegung des Patiententischs 19 übertragen wird.

Der Patiententisch 19 weist für eine Bewegung innerhalb des Patientenaufnahmebereichs 15 zumindest drei Freiheitsgrade 22, 23, 24, 25 bevorzugt vier Freiheitsgrade 22, 23, 24, 25 auf. Ein erster Freiheitsgrad 22 umfasst eine Bewegung des Patiententischs 19 in Längsrichtung oder z-Richtung des Patientenaufnahmebereichs 15. Ein zweiter Freiheitsgrad 23 umfasst eine Bewegung des Patiententischs 19 in Querrichtung oder x-Richtung des Patientenaufnahmebereichs 15. Ein dritter Freiheitsgrad 24 umfasst eine Bewegung des Patiententischs 19 in Vertikalrichtung oder y-Richtung des Patientenaufnahmebereichs 15. Ein vierter Freiheitsgrad 35 kann eine Drehbewegung und/oder Rotationsbewegung des Patiententischs 19 um eine Vertikalachse 26 des Patientenaufnahmebereichs 15 umfassen. Bevorzugt verläuft die Vertikalachse 26 für die Drehbewegung und/oder Rotationsbewegung durch ein Isozentrum der Magneteinheit 11.

Der Patiententisch 19 umfasst zudem Sensoren 27, die innerhalb des Patiententischs 19 angeordnet sind. Die einzelnen Sensoren 27 sind zu einem Erfassen einer Biegung des Patiententischs 19 in Längsrichtung des Patiententischs 19 ausgebildet. Dabei können die einzelnen Sensoren 27 beispielsweise als optische Glasfasersensoren ausgebildet sein. Alternativ oder zusätzlich können die einzelnen Sensoren 27 auch zu einer Erfassung eines Patientengewichts ausgebildet sein.

Der Grundmagnet 12 der Magneteinheit 11 ist zu einem Erzeugen eines starken und insbesondere konstanten Grundmagnetfelds 28 ausgebildet. Dabei kann der Grundmagnet 12 beispielsweise als supraleitender Grundmagnet 12 oder auch als Dauermagnet ausgebildet sein. Die Gradientenspuleneinheit 13 der Magneteinheit 11 ist zu einer Erzeugung von Magnetfeldgradienten, die für eine Ortskodierung während einer Bildgebung verwendet werden, ausgebildet. Die Gradientenspuleneinheit 13 wird mittels einer Gradientensteuereinheit 29 der Magnetresonanzvorrichtung 10 gesteuert. Die Hochfrequenzantenneneinheit 14 der Magneteinheit 10 ist zu einer Anregung einer Polarisation, die sich in dem von dem Grundmagneten 12 erzeugten Grundmagnetfeld 28 einstellt, ausgebildet. Die Hochfrequenzantenneneinheit 14 wird von einer Hochfrequenzantennensteuereinheit 30 der Magnetresonanzvorrichtung 10 gesteuert und strahlt hochfrequente Magnetresonanzsequenzen in den Patientenaufnahmebereich 15 der Magnetresonanzvorrichtung 10 ein.

Zu einer Steuerung des Grundmagneten 12, der Gradientensteuereinheit 29 und zur Steuerung der Hochfrequenzantennensteuereinheit 30 weist die Magnetresonanzvorrichtung 10 eine Systemsteuereinheit 31 auf. Die Systemsteuereinheit 31 steuert zentral die Magnetresonanzvorrichtung 10, wie beispielsweise das Durchführen einer vorbestimmten bildgebenden Gradientenechosequenz. Zudem umfasst die Systemsteuereinheit 31 eine nicht näher dargestellte Auswerteeinheit zu einer Auswertung von medizinischen Bilddaten, die während der Magnetresonanzuntersuchung erfasst werden.

Des Weiteren umfasst die Magnetresonanzvorrichtung 10 eine Benutzerschnittstelle 32, die mit der Systemsteuereinheit 31 verbunden ist. Steuerinformationen wie beispielsweise Bildgebungsparameter, sowie rekonstruierte Magnetresonanzbilder können auf einer Darstellungseinheit 33, beispielsweise auf zumindest einem Monitor, der Benutzerschnittstelle 32 für ein medizinisches Bedienpersonal angezeigt werden. Weiterhin weist die Benutzerschnittstelle 32 eine Eingabeeinheit 34 auf, mittels der Informationen und/oder Parameter während eines Messvorgangs von dem medizinischen Bedienpersonal eingegeben werden können.

Des Weiteren weist die Magnetresonanzvorrichtung 10 eine Kamera 35 auf, die außerhalb des Patientenaufnahmebereichs 15 angeordnet ist. Die Kamera 35 umfasst im vorliegenden Ausführungsbeispiel eine 3D-Kamera. Die Kamera 35 ist im vorliegenden Ausführungsbeispiel an einer Decke eines Untersuchungsraums angeordnet, wobei innerhalb des Untersuchungsraums die Magneteinheit 11 der Magnetresonanzvorrichtung 10 angeordnet ist. Alternativ hierzu kann die Kamera 35 auch an einer Frontseite der Magneteinheit 11 angeordnet sein. Die Kamera 35 weist ein Sichtfeld 36 auf, wobei sich das Sichtfeld 36 von oben auf einen Bereich vor der Magneteinheit 11 erstreckt, insbesondere einen an die Frontseite der Magneteinheit 11 angrenzenden Bereich.

Die dargestellte Magnetresonanzvorrichtung 10 kann selbstverständlich weitere Komponenten umfassen, die Magnetresonanzvorrichtungen 10 gewöhnlich aufweisen. Eine allgemeine Funktionsweise einer Magnetresonanzvorrichtung 10 ist zudem dem Fachmann bekannt, so dass auf eine detaillierte Beschreibung der weiteren Komponenten verzichtet wird.

In Fig. 2 ist ein erfindungsgemäßes Verfahren zu einem Bereitstellen eines Kollisionsvermeidungsmodells für eine Bewegung des Patiententischs 19 innerhalb des Patientenaufnahmebereichs 15 dargestellt. Das Verfahren wird von einer Recheneinheit 37 der Magnetresonanzvorrichtung 10 gesteuert. Die Recheneinheit 37 weist hierzu einer erforderliche Software und/oder Computerprogramme auf, die bei einem Ausführen mittels eines Prozessors der Recheneinheit 37 eine Steuerung des Verfahrens bewirken.

Zu Beginn des Verfahrens befindet sich der Patiententisch 19 außerhalb des Patientenaufnahmebereichs 15. Der Patiententisch 19 ist hierbei in einem Frontbereich vor der Magnetresonanzvorrichtung 10 angeordnet. Dabei kann sich der Patiententisch 19 in einer definierten Startposition, deren Positionsinformationen bekannt und vorbestimmt sind, befinden. Alternativ hierzu kann sich der Patiententisch 19 hierbei in einer beliebigen Ausgangssituation befinden, deren Positionsinformationen erst noch bestimmt werden müssen.

In einem ersten Verfahrensschritt 100 erfolgt eine Bereitstellen von zumindest einer Größeninformation und/oder Positionsinformation des Patiententischs 19 mittels einer Bereitstellungseinheit 38. Befindet sich der Patiententisch 19 in einer definierten Startposition mit vorbestimmten Positionsinformationen, kann die zumindest eine Positionsinformation und/oder die Größeninformation des Patiententischs 19 aus einer Speichereinheit in diesem ersten Verfahrensschritt 100 ausgelesen werden. Dabei kann die Bereitstellungseinheit 38 von der Recheneinheit 37, insbesondere einer Speichereinheit der Recheneinheit 37, umfasst sein.

Befindet sich der Patiententisch 19 dagegen in einer beliebigen Ausgangsposition bezüglich der Magneteinheit 11 und/oder des Patientenaufnahmebereichs 15, kann das Bereitstellen der zumindest einen Größeninformation und/oder Positionsinformation in diesem ersten Verfahrensschritt 100 auch ein Erfassen der zumindest einen Größeninformation und/oder Positionsinformation des Patiententischs 19 umfassen. Hierbei umfasst die Bereitstellungseinheit 38 insbesondere eine Erfassungseinheit, insbesondere die Kamera 35, bevorzugt eine 3D-Kamera, zum Erfassen der zumindest einen Größeninformation und/oder Positionsinformation des Patiententischs 19. Bevorzugt ist hierbei die Ausgangsposition des Patiententischs 19 innerhalb des Sichtfelds 36 der Kamera 35 angeordnet.

Die zumindest eine Größeninformation umfasst bevorzugt eine Ausdehnung des Patiententischs 19 in zumindest zwei Raumrichtungen x, y, z, bevorzugt in drei Raumrichtungen x, y, z. Insbesondere umfasst die Größeninformation des Patiententischs 19 eine Länge des Patiententischs 19 und eine Breite des Patiententischs 19. Bevorzugt umfasst die Größeninformation des Patiententischs 19 auch eine Höhe des Patiententischs 19. Die Positionsinformation umfasst bevorzugt eine Position des Patiententischs 19 bezüglich des Patientenaufnahmebereichs 15.

In diesem ersten Verfahrensschritt 100 kann das Bereitstellen der zumindest einen Größeninformation und/oder Positionsinformation des Patiententischs 19 auch eine Größeninformation und/oder Positionsinformation einer am Patiententisch 19 angeordneten Zubehöreinheit 39 umfassen. Eine derartige Zubehöreinheit 39 kann beispielsweise eine Armauflage und/oder weitere Lagerungselemente umfassen, deren Ausdehnung sich über den Patiententisch 19 hinaus, insbesondere über eine Lagerungsfläche 40 des Patiententischs 19 hinaus, erstreckt.

In einem weiteren zweiten Verfahrensschritt 101 erfolgt zunächst ein Positionieren des Patienten 16 auf dem Patiententisch 19. Anschließend erfolgt ein Erfassen von Bilddaten des auf dem Patiententisch 19 positionierten Patienten 16. Zu einem Erfassen der Bilddaten weist die Magnetresonanzvorrichtung 10 eine Erfassungseinheit 41 auf. Dabei kann die Erfassungseinheit 41 zum Erfassen der Bilddaten die Kamera 35, insbesondere die 3D-Kamera, umfassen. Hierzu befindet sich der Patiententisch 19 zusammen mit dem Patienten 16 außerhalb des Patientenaufnahmebereichs 15, insbesondere im Sichtfeld 36 der Kamera 35.

Alternativ hierzu kann die Erfassungseinheit 41 zum Erfassen von Bilddaten die Magneteinheit 11 umfassen. Hierzu wird zunächst der Patiententisch 19 zusammen mit dem Patienten 16 in einer zentralen Position innerhalb des Patientenaufnahmebereichs 15 positioniert, bei der eine Kollision des Patienten 16 und/oder des Patiententischs 19 mit einer den Patientenaufnahmebereich 15 umgebenden Umhausung 42 ausgeschlossen ist und/oder eine Wahrscheinlichkeit einer Kollision sehr gering ist. Das Erfassen von Bilddaten, insbesondere Magnetresonanzdaten, kann mittels eines schnellen Lokalisierungs-Scans erfolgen. Mittels des Lokalisierungs-Scans werden bevorzugt Schichten mit unterschiedlicher räumliche Orientierung erfasst. Dabei wird zumindest eine transversale Schicht oder auch mehrere Schichten, die auch eine andere Orientierung aufweisen können, des Patienten innerhalb des Patientenaufnahmebereichs erfasst.

In einem weiteren, dritten Verfahrensschritt 102 wird zumindest eine Größeninformation und/oder Positionsinformation des auf dem Patiententisch 19 positionierten Patienten 16 anhand der in dem zweiten Verfahrensschritt 101 erfassten Bilddaten ermittelt. Das Ermitteln der zumindest einen Größeninformation und/oder Positionsinformation des auf dem Patiententisch 19 positionierten Patienten 16 erfolgt bevorzugt mittels einer Ermittlungseinheit 43. Bevorzugt ist die Ermittlungseinheit 43 von der Recheneinheit 37 umfasst.

Die Größeninformation des auf dem Patiententisch 19 positionierten Patienten 16 umfasst bevorzugt eine Ausdehnung des Patienten 16 in zumindest zwei Raumrichtungen x, y, z, bevorzugt in drei Raumrichtungen x, y, z. Insbesondere umfasst die Größeninformation des Patienten 16 eine Länge des Patienten 16 und eine Breite des Patienten 16. Bevorzugt umfasst die Größeninformation des Patienten 16 auch eine Dicke des Patienten 16. Die Positionsinformation des auf dem Patiententisch 19 positionierten Patienten 16 umfasst bevorzugt eine Position des Patienten 16 bezüglich des Patiententischs 19.

Erfolgt das Erfassen der Bilddaten mittels der Kamera 35, werden in diesem dritten Verfahrensschritt 102 bei der Ermittlung Größeninformation und/oder Positionsinformation des auf dem Patiententisch 19 positionierten Patienten 16 zusätzlich Projektionseffekte reduziert und/oder eliminiert. Dabei wird anhand der erfassten Bilddaten eine Ausdehnung des Patienten 16 bezüglich einer Geometrie und/oder Ausdehnung des Patiententischs 19 bestimmt. Umfasst die Kamera 35 eine 3D-Kamera, kann die Ausdehnung des Patienten 16 direkt aus den erfassten Bilddaten ermittelt werden. Insbesondere kann derart direkt aus den erfassten Bilddaten eine dreidimensionale Ausdehnung des Patienten 16, insbesondere eine seitliche Ausdehnung und eine Höhe des Patienten 16, bestimmt werden. Zudem können auch Größeninformationen und/oder Positionsinformationen von Zubehöreinheiten 39 dazu verwendet werden, eine Ausdehnung des Patienten 16 zu bestimmen, wie beispielsweise seitlich angeordnete Armauflagen am Patiententisch 19. Erfolgt das Erfassen der Bilddaten mittels der Magneteinheit 11, werden bevorzugt in diesem dritten Verfahrensschritt 102 zur Ermittlung der Größeninformation und/oder Positionsinformation des Patienten 16 zusätzliche Patienteninformationen berücksichtigt. Beispielsweise können diese zusätzlichen Patienteninformationen eine Größe und/oder ein Gewicht und/oder ein Alter und/oder ein Geschlecht des Patienten 16 umfassen. Dabei kann anhand der aus den Bilddaten ermittelten Größeninformationen, insbesondere aus Magnetresonanzbilddaten ermittelte Größeninformationen, des Patienten 16 zusammen mit diesen zusätzlichen Informationen ein Patientenmodell, bevorzugt ein 3D-Patientenmodell, bestimmt werden.

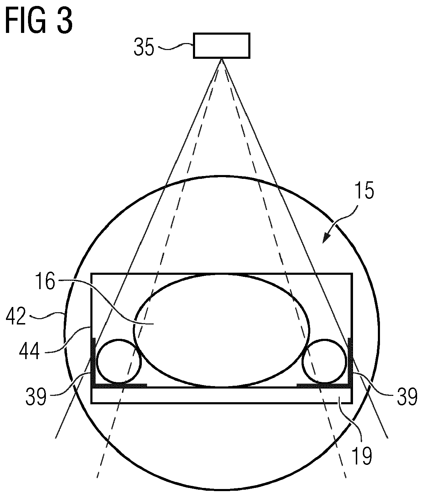

Daran anschließend erfolgt in einem vierten Verfahrensschritt 103 ein Ermitteln des Kollisionsvermeidungsmodells mittels der Ermittlungseinheit 43. In die Ermittlung des Kollisionsvermeidungsmodells gehen sowohl die Größeninformationen und/oder Positionsinformationen des Patiententischs 19 als auch die Größeninformationen und/oder Positionsinformationen des Patienten 16 ein. Bei der Ermittlung des Kollisionsvermeidungsmodells werden zunächst geometrische Modelle 44 verwendet, die anhand der Größeninformationen und/oder Positionsinformationen des Patiententischs 19 als auch die Grö-ßeninformationen und/oder Positionsinformationen des Patienten 16 bestimmt werden. Beispielsweise kann ein derartiges geometrisches Modell 44 eine maximale seitliche Ausdehnung, insbesondere eine Ausdehnung in x-Richtung und/oder Quererstreckung des Patiententischs 19, des Patienten 16 und/oder des Patiententischs 19 und eine maximale vertikale Ausdehnung, insbesondere eine Ausdehnung in y-Richtung, des Patienten 16 zusammen mit dem Patiententisch 19 umfassen (Fig. 3). Derart kann im einfachsten Fall anhand dieser Punkte oder Ausdehnungen ein in der x-y-Ebene ein Rechteck festgelegt werden, anhand dessen als 3D-Modell 44 ein Cubus und/oder Zylinder ermittelt und/oder festgelegt wird. Zudem sind weitere geometrische Formen, beispielsweise eine elliptische Grundfläche mit einem elliptischen Zylinder usw., denkbar. Diese geometrischen Modelle 44 sind in der Speichereinheit der Recheneinheit 37 gespeichert, wobei hierbei jeweils unterschiedlichen Größeninformationen des Patienten 16 und/oder des Patiententischs 19 unterschiedlichen Modellen 44 zugeordnet sind.

Das Kollisionsvermeidungsmodells wird insbesondere zu einer Simulation und/oder Modellierung einer Bewegung des Patiententischs 19 mit darauf positionierten Patienten 16 verwendet. Dabei geht in des Kollisionsvermeidungsmodells auch eine Größe und/oder Ausdehnung des Patientenaufnahmebereichs 15, insbesondere der den Patientenaufnahmebereich 15 umgebenden Umhausung 42, ein.

In Fig. 3 ist ein von der Kamera 35 erfasstes Bild des Patiententischs 19 zusammen mit einem von der Kamera 35 erfassten Bild des Patienten 16 dargestellt. Anhand der daraus ermittelten Größeninformationen und/oder Positionsinformationen ist ein Modell 44 ermittelt worden, dass ebenfalls in Fig. 3 dargestellt ist. Zudem ist diesem Modell 44 zusätzlich eine Größe und/oder Ausdehnung des Patientenaufnahmebereichs 15, insbesondere der den Patientenaufnahmebereich 15 umgebenden Umhausung 42, überlagert.

In einem fünften Verfahrensschritt 104 erfolgt ein Bereitstellen des Kollisionsvermeidungsmodells für eine Bewegung des Patiententischs 19 innerhalb des Patientenaufnahmebereichs 15. Das Bereitstellen erfolgt hierbei mittels einer weiteren Bereitstellungseinheit 45, die von der Recheneinheit 37 umfasst ist.

In einem sechsten Verfahrensschritt 105 wird anhand des bereitgestellten Kollisionsvermeidungsmodells eine Zielposition des Patiententischs 19 und/oder eine Bewegung des Patiententischs 19 in die Zielposition innerhalb des Patientenaufnahmebereichs 15 ermittelt. Das Ermitteln der Zielposition erfolgt mittels der Ermittlungseinheit 43, wobei das Kollisionsvermeidungsmodell direkt von der weiteren Bereitstellungseinheit 45 an die Ermittlungseinheit 43 bereitgestellt wird.

Insbesondere wird hierbei eine kollisionsfreie Bewegung des Patiententischs 19 in die Zielposition innerhalb des Patientenaufnahmebereichs 15 ermittelt. Beispielsweise kann hierbei anhand des Kollisionsvermeidungsmodells ein Modell des Patienten 16 zusammen mit dem Patiententisch 19 einem Modell des Patientenaufnahmebereichs 15 überlagert werden. Die Zielposition kann dabei eine Position, in der der zu untersuchende Bereich des Patienten 16 einen minimalen Abstand zum Isozentrum der Magneteinheit 11 aufweist, umfassen. Beispielsweise umfasst die Zielposition eine Untersuchungsposition, in der der zu untersuchende Bereich des Patienten 16 für eine Magnetresonanzuntersuchung positioniert ist. Zudem kann die Zielposition auch eine weitere Position des Patiententischs 19 innerhalb des Patientenaufnahmebereichs 15 umfassen. Das Kollisionsvermeidungsmodell wird bevorzugt bei jeder Bewegung des Patiententischs 19 innerhalb des Patientenaufnahmebereichs 15 verwendet, um eine sichere und Kollisionsfreie Bewegung des Patiententischs 19 zu ermöglichen. Zudem kann auch eine geplante Bewegung des Patiententischs 15 von der Ermittlungseinheit 43 in mehrere Teilschritte unterteilt werden, wobei eine Bewegung für jeden der Teilschritte auf Grundlage des Kollisionsvermeidungsmodells ermittelt wird.

Anschließend wird in diesem sechsten Verfahrensschritt 105 der Patiententisch 19 in dieser Zielposition positioniert. Eine Steuerung der Positionierung des Patiententischs 19 erfolgt mittels der Recheneinheit 37, die hierzu die Antriebseinheit 21 und die Einstellungseinheit 20 der Patientenlagerungsvorrichtung 18 entsprechend ansteuert. Zudem kann die Positionierung des Patiententischs 19 auch manuell durch einen Benutzer gesteuert werden.

Nach einem Positionieren des Patiententischs 19 in dieser Zielposition erfolgt in einem weiteren, siebten Verfahrensschritt 106 ein Überwachen einer Position des Patiententischs 19 und/oder des Patienten 16, wobei eine Positionsänderung des Patiententischs 19 und/oder des Patienten 16 zu einer Korrektur des Kollisionsvermeidungsmodells verwendet wird.

Die Korrektur des Kollisionsvermeidungsmodell erfolgt durch die Ermittlungseinheit 43. Beispielsweise kann eine Positionsänderung des Patienten 16 und/oder des Patiententischs 19 zu einer Änderung des ermittelten geometrischen Modells 44 führen. Beispielsweise kann dies zu einem Verschieben und/oder Drehen eines Modells 44 führen. Zudem sind auch Änderungen in den Abmessungen des Modells 44 denkbar, beispielsweise eine größere oder kleinere Grundfläche des Modells 44.

Eine Positionsänderung des Patiententischs 19 kann sich beispielsweise ergeben, wenn ein schwerer Patient 16 auf dem Patiententisch 19 liegt und wenn der Patientenaufnahmebereich 15 kein Abstützungselement und/oder Lagerelement zur Abstützung und/oder Lagerung des Patiententischs 19 aufweist. In derartigen Fällen kann es zu einer Biegung des Patiententischs 19 führen. Zudem kann auch bei einem Abstützen und/oder Auflegen eines medizinischen Personals, beispielsweise eines Arztes, für einen medizinischen Eingriff und/oder einer medizinischen Intervention, während einer Magnetresonanzuntersuchung eine Biegung des Patiententischs 19 verursacht werden. Vorzugsweise erfolgt während der gesamten Magnetresonanzuntersuchung eine stetige Überwachung einer Position des Patiententischs 19, so dass stets eine aktuelle Position und/oder eine temporäre Biegung des Patiententischs 19 bei der Bestimmung der Zielposition berücksichtigt werden kann.

Das Überwachen der Position des Patiententischs 19 kann dabei mittels der Magneteinheit 11 erfolgen, indem beispielsweise sagittale Schnittbilder während der Magnetresonanzuntersuchung hierzu erfasst und ausgewertet werden. Dabei kann eine Anatomie des Patienten 16 anhand definierter Landmarken vermessen werden oder es können zusätzliche Marker, insbesondere am Patiententisch 19, angeordnet sein, so dass anhand der Anatomie des Patienten 16 und/oder der Position der Marker in den Magnetresonanzdaten eine Positionsänderung, insbesondere eine Biegung, des Patiententischs 19 ermittelt werden kann.

Alternativ oder zusätzlich kann die Erfassung eine Positionsänderung, insbesondere einer Biegung, des Patiententischs 19 auch mittels der Sensoren 27, die innerhalb des Patiententischs 19 angeordnet sind, erfasst werden.

Eine Positionsänderung des Patienten 16 kann auf unerwünschten Bewegungen des Patienten 16 resultieren, die dieser während der Magnetresonanzuntersuchung ausführt. Derartige Bewegungen des Patienten 16 während der Magnetresonanzuntersuchung werden bevorzugt mittels von der Magneteinheit 11 erfassten Magnetresonanzdaten erfasst.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zu einem Bereitstellen eines Kollisionsvermeidungsmodells für eine Bewegung eines Patiententischs innerhalb eines Patientenaufnahmebereich einer Magnetresonanzvorrichtung, wobei dem Patiententisch für eine Bewegung innerhalb des Patientenaufnahmebereichs zumindest zwei Freiheitgrade zur Verfügung stehen, umfassend die folgenden Verfahrensschritte:
- Bereitstellen von zumindest einer Größeninformation und/oder Positionsinformation des Patiententischs,
- Erfassen von Bilddaten eines auf dem Patiententisch positionierten Patienten,
- Ermitteln von zumindest einer Größeninformation und/oder Positionsinformation des auf dem Patiententisch positionierten Patienten anhand der erfassten Bilddaten,
- Ermitteln des Kollisionsvermeidungsmodells anhand der zumindest einen Größeninformation und/oder Positionsinformation des Patiententischs und anhand der zumindest einen Größeninformation und/oder Positionsinformation des Patienten, und
- Bereitstellen des Kollisionsvermeidungsmodells für eine Bewegung des Patiententischs innerhalb des Patientenaufnahmebereichs.

2. Verfahren nach Anspruch 1,
**dadurch gekennzeichnet, dass** das Bereitstellen der zumindest einen Größeninformation und/oder Positionsinformation des Patiententischs eine Größeninformation und/oder Positionsinformation einer am Patiententisch angeordnete Zubehöreinheit umfasst.

3. Verfahren nach einem der vorhergehenden Ansprüche,
**dadurch gekennzeichnet, dass** Erfassen der Bilddaten mittels einer Kamera erfolgt, wobei die Kamera außerhalb des Patientenaufnahmebereichs angeordnet ist.

4. Verfahren nach einem der vorhergehenden Ansprüche,
**dadurch gekennzeichnet, dass** das Erfassen der Bilddaten mittels einer Magneteinheit der Magnetresonanzvorrichtung erfolgt.

5. Verfahren nach einem der vorhergehenden Ansprüche,
**dadurch gekennzeichnet, dass** bei der Ermittlung der zumindest einen Größeninformation und/oder Positionsinformation des auf dem Patiententisch positionierten Patienten Projektionseffekte reduziert werden.

6. Verfahren nach einem der vorhergehenden Ansprüche,
**dadurch gekennzeichnet, dass** zur Ermittlung der zumindest einen Größeninformation und/oder Positionsinformation des Patienten zusätzliche Patienteninformationen berücksichtigt werden.

7. Verfahren nach einem der vorhergehenden Ansprüche,
**dadurch gekennzeichnet, dass** zur Ermittlung des Kollisionsvermeidungsmodells geometrische Modelle verwendet werden, wobei eine Zuordnung der geometrischen Modelle zu der zumindest einen Größeninformation des Patienten in einer Speichereinheit gespeichert ist.

8. Verfahren nach einem der vorhergehenden Ansprüche,
**dadurch gekennzeichnet, dass** anhand des bereitgestellten Kollisionsvermeidungsmodells eine Bewegung des Patiententischs kontrolliert wird.

9. Verfahren nach Anspruch 8,
**dadurch gekennzeichnet, dass** nach einem Positionieren des Patiententischs eine Positionsüberwachung des Patiententischs hinsichtlich einer Biegung des Patiententischs erfolgt, wobei die Überwachung mittels der Magneteinheit und/oder zumindest eines am Patiententisch angeordneten Sensors erfolgt.

10. Verfahren nach einem der vorhergehenden Ansprüche,
**dadurch gekennzeichnet, dass** nach einem Positionieren des Patiententischs eine Überwachung einer Position des Patienten erfolgt.

11. Verfahren nach einem der Ansprüche 9 bis 10,
**dadurch gekennzeichnet, dass** eine Korrektur des Kollisionsvermeidungsmodells anhand der Positionsänderung des Patienten und/oder der Positionsänderung des Patiententischs ermittelt wird.

12. Magnetresonanzvorrichtung mit einer Magneteinheit, einen von der Magneteinheit zumindest teilweise umgebenen Patientenaufnahmebereich und einen innerhalb des Patientenaufnahmebereichs bewegbaren Patiententisch, wobei die Magnetresonanzvorrichtung zu einem Ausführen eines Verfahrens zu einem Bereitstellen eines Kollisionsvermeidungsmodells für eine Bewegung des Patiententischs in dem Patientenaufnahmebereich nach einem der vorhergehenden Ansprüche ausgebildet ist.

13. Magnetresonanzvorrichtung nach Anspruch 12,
**dadurch gekennzeichnet, dass** der Patiententisch für eine Bewegung innerhalb des Patientenaufnahmebereichs zumindest zwei Freiheitsgrade aufweist.

14. Magnetresonanzvorrichtung nach einem der Ansprüche 12 bis 13,
**gekennzeichnet durch** eine Kamera, die außerhalb des Patientenaufnahmebereichs angeordnet ist und die zu einer Erfassung zumindest einer Größeninformation und/oder einer Positionsinformation des Patienten und/oder des Patiententischs ausgebildet ist.

15. Magnetresonanzvorrichtung nach einem der Ansprüche 12 bis 14,
**dadurch gekennzeichnet, dass** der Patiententisch zumindest einen Sensor aufweist, der zu einem Erfassen einer Biegung des Patiententischs und/oder zu einem Erfassen eines Patientengewichts ausgebildet ist.

16. Computerprogrammprodukt, welches ein Programm umfasst und direkt in einen Speicher einer programmierbaren Recheneinheit ladbar ist, mit Programmmitteln, um ein Verfahren zu einem Bereitstellen eines Kollisionsvermeidungsmodells für eine Bewegung eines Patiententischs in einem Patientenaufnahmebereich einer Magnetresonanzvorrichtung nach einem der Ansprüche 1 bis 11 auszuführen, wenn das Programm in der Recheneinheit ausgeführt wird.
